# FASCICULE DE BREVET EUROPEEN

(11) **EP 0 576 381 B1**
(45) Date de publication et mention de la délivrance du brevet: **23.10.1996**
(21) Numéro de dépôt: 93440050.8
(22) Date de dépôt: 23.06.1993
(51) Int. Cl.: G05F 7/00, H03L 7/04

(54) **Dispositif d'asservissement d'un champ magnétique et procédé mettant en oeuvre ledit disposititf**
Verfahren und Vorrichtung zur Servosteuerung eines magnetischen Feldes
Method and device for the servo-control of a magnetic field

(30) Priorité: 24.06.1992 FR 9207947
(43) Date de publication de la demande: 29.12.1993
(73) Titulaire: SADIS BRUKER SPECTROSPIN, SOCIETE ANONYME DE DIFFUSION DE L'INSTRUMENTATION SCIENTIFIQUE BRUKER SPECTROSPIN, F-67160 Wissembourg (FR)
(72) Inventeur: Schmalbein, Dieter, 7501 Marxzell - Burbach (DE); Ringeisen, Victor, 67160 Riedseltz (FR)
(74) Mandataire: Nuss, Pierre

(56) Documents cités:
- DE-A- 2 953 035
- FR-A- 2 415 387
- FR-A- 2 597 656

## Description

La présente invention concerne le domaine de la commande et du contrôle des paramètres, notamment de l'intensité, d'un champ magnétique et a pour objet un dispositif d'asservissement d'un champ magnétique, ainsi qu'un procédé mettant en oeuvre ledit dispositif.

Il existe actuellement déjà différents dispositifs pour la mesure et l'asservissement d'un champ magnétique.

Ainsi, on connaît notamment, en tant que capteurs de mesure, faisant partie de dispositifs d'asservissement, les sondes à effet Hall, les éléments à résistance variable en fonction du champ magnétique environnant et les gaussmètres à bobine tournante.

En outre, il est également connu de réaliser un asservissement d'un champ magnétique basé sur un signal d'absorption de résonance paramagnétique électronique ou de résonance magnétique nucléaire.

Néanmoins, chacun de ces dispositifs et procédés de mesure et d'asservissements connus présente un ou plusieurs inconvénients quant à leurs performances ou à leurs possibilités de mise en oeuvre, à savoir, soit une résolution ou une précision de mesure et d'asservissement relativement faible, soit une plage de fonctionnement limitée, ou encore la nécessité de disposer d'un appareillage complexe, entraînant, notamment, des réglages longs et fastidieux.

Par ailleurs, on connaît également par le document DE-A-2 953 035, un dispositif de stabilisation de champs magnétiques comprenant essentiellement un capteur sous la forme d'un filtre hyperfréquence au grenat d'yttrium ferreux dont la fréquence centrale est réglée en fonction de la valeur du champ magnétique à obtenir.

Ce dispositif comporte également un détecteur mesurant le signal issu dudit filtre après application d'un signal de référence et un dispositif de comparaison du signal de référence original avec le signal issu du filtre précité et de génération d'un signal correcteur, relié à une bobine de correction.

Toutefois, ce dispositif n'utilise pas directement la fréquence, qui constitue pourtant la grandeur physique résultant directement de la transformation opérée par le capteur au grenat d'yttrium ferreux et que l'on peut mesurer avec une très grande précision, en tant que paramètre correcteur mais le décalage de phase du signal de référence.

De plus, ce dispositif ne permet pas un réglage positif et actif de la valeur du champ magnétique par l'entremise du capteur et de la boucle correctrice associée.

Le problème posé à la présente invention consiste par conséquent à concevoir un dispositif d'asservissement d'un champ magnétique présentant, d'une part, une très bonne résolution, ainsi qu'une très bonne précision de mesure et d'asservissement, d'autre part, une large plage de fonctionnement et, enfin, une structure simple permettant un réglage rapide, plus particulièrement de la valeur de consigne du champ magnétique à asservir.

A cet effet, la présente invention a pour objet un dispositif d'asservissement d'un champ magnétique, comportant un capteur disposé dans le champ magnétique à asservir et une boucle d'asservissement contrôlant le module d'alimentation de l'aimant générateur dudit champ magnétique, ledit capteur se présentant sous la forme d'un oscillateur hyperfréquence à résonateur au grenat d'yttrium ferreux, générant un signal de mesure dont la fréquence est proportionnelle à l'intensité du champ magnétique, caractérisé en ce que la boucle d'asservissement est composée, d'une part, d'un dispositif de traitement et de mise en forme du signal de mesure délivré par le capteur, constitué par un mélangeur harmonique combinant le signal de mesure issu du capteur avec un signal de référence délivré par un oscillateur à grande stabilité, le signal composé résultant étant soumis à un filtre passe-bande, et, d'autre part, d'un dispositif de comparaison de la fréquence dudit signal de mesure avec celle d'un signal de consigne et de génération d'un signal correcteur, qui comporte un mélangeur harmonique, recevant le signal traité et mis en forme et le combinant avec un signal de consigne issu d'un synthétiseur hyperfréquence (11) programmable, et un discriminateur de fréquence consécutif, relié à un générateur d'un signal de correction correspondant délivré au module d'alimentation de l'aimant à contrôler.

L'invention a également pour objet un procédé d'asservissement d'un champ magnétique, mettant en oeuvre le dispositif décrit ci-dessus et caractérisé en ce qu'il consiste essentiellement à générer, par l'intermédiaire d'un oscillateur à résonateur au grenat d'yttrium ferreux, un signal de mesure dont la fréquence est proportionnelle à l'intensité du champ magnétique généré par l'aimant à contrôler, à mélanger ensuite ledit signal de mesure avec un signal de référence, puis à mélanger, après filtrage, le signal composé résultant avec un signal de consigne, au moyen d'un mélangeur harmonique, à démoduler le signal ainsi obtenu en effectuant une discrimination de fréquence et, enfin, à délivrer un signal de correction, fonction de l'écart de fréquence entre le signal composé et le signal de consigne, au module d'alimentation de l'aimant générateur du champ magnétique à asservir.

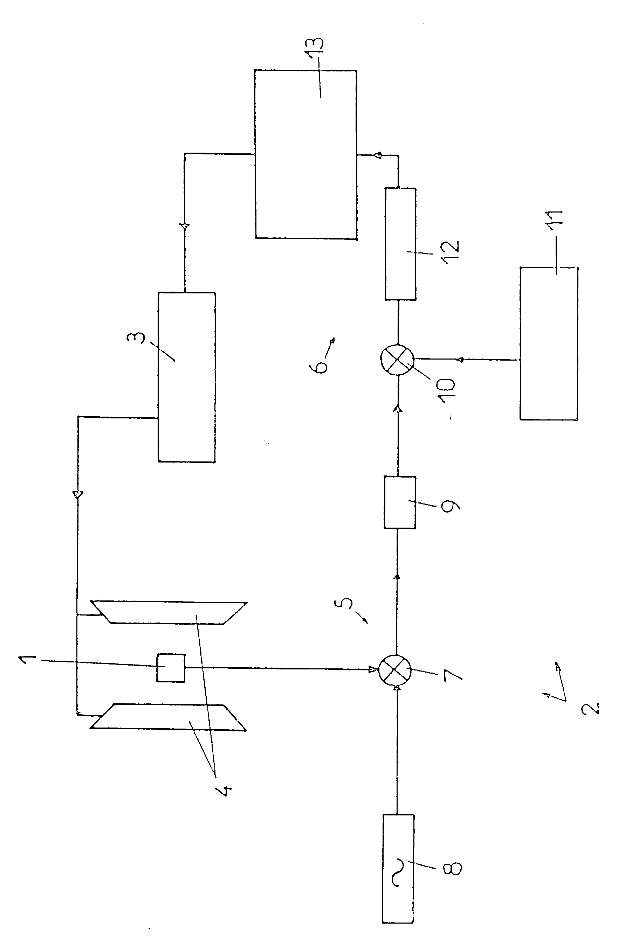

L'invention sera mieux comprise grâce à la description ci-après, qui se rapporte à un mode de réalisation préféré, donné à titre d'exemple non limitatif, et expliqué avec référence au dessin annexé, dont la figure unique est un schéma synoptique du dispositif d'asservissement selon l'invention.

Conformément à l'invention, et comme le montre la figure du dessin annexé, le dispositif d'asservissement d'un champ magnétique comporte un capteur 1 sous la forme d'un oscillateur hyperfréquence à résonateur au grenat d'yttrium ferreux, la boucle d'asservissement 2 étant principalement composée, d'une part, d'un dispositif 5 de traitement et de mise en forme du signal de mesurc délivré par ledit capteur 1 et, d'autre part, d'un dispositif 6 de comparaison de la fréquence dudit signal de mesure avec celle d'un signal de référence, et de génération d'un signal correcteur, relié au module d'alimentation 3 de l'aimant 4 à contrôler.

Selon une caractéristique de l'invention, le dispositif 5 de traitement est constitué par un mélangeur harmonique 7 combinant le signal de mesure issu du capteur 1 avec un signal de référence délivré par un oscillateur 8 à grande stabilité, le signal composé résultant étant soumis à un filtre passe-bande 9, ce dernier ne laissant subsister qu'une des composantes fréquentielles dudit signal composé.

Comme le montre également la figure du dessin annexé, le dispositif 6 de comparaison et de génération d'un signal correcteur comporte un mélangeur harmonique 10 recevant le signal traité et mis en forme et le combinant avec un signal de consigne issu d'un synthétiseur hyperfréquence 11 programmable, et un discriminateur de fréquence 12 consécutif, relié à un générateur 13 de signal de correction correspondant, délivré au module d'alimentation 3.

Ainsi, la différence de fréquences variable entre le signal de mesure filtré et le signal de consigne, fourni par le synthétiseur de fréquence programmé par l'utilisateur et qui dépend directement de la valeur du champ magnétique pour laquelle l'aimant 4 doit être asservi, est transformée en un signal à amplitude variable proportionnelle, exploité par le générateur de signal de correction 13.

La constitution et le mode de fonctionnement des différents dispositifs électroniques 1, 3 et 5 à 13 décrits ci-dessus, connus de l'homme de métier, ne seront pas décrits de manière plus précise dans la présente demande.

L'invention a également pour objet un procédé d'asservissement de champ magnétique, mettant en oeuvre le dispositif d'asservissement décrit précédemment, consistant essentiellement à générer par l'intermédiaire, d'un oscillateur 1 à résonateur au grenat d'yttrium ferreux utilisé comme capteur, un signal de mesure dont la fréquence est proportionnelle à l'intensité du champ magnétique généré par l'aimant à contrôler, à mélanger ensuite ledit signal de mesure avec un signal de référence, puis à mélanger, après filtrage, le signal composé résultant avec un signal de consigne, au moyen d'un mélangeur harmonique 10, à démoduler le signal ainsi obtenu en effectuant une discrimination de fréquence et, enfin, à délivrer un signal de correction, fonction de l'écart de fréquence entre le signal composé et le signal de consigne, au module d'alimentation 3 de l'aimant 4 générateur du champ magnétique à asservir.

Grâce à l'invention, il est donc possible de réaliser un dispositif d'asservissement de champ magnétique permettant de mettre en oeuvre les techniques à très hautes résolution et précision de la mesure de fréquence dans le domaine des hyperfréquences, par l'intermédiaire d'un oscillateur comportant un résonateur à grenat d'yttrium ferreux, dont la fréquence du signal émis dépend linéairement du champ magnétique environnant.

Les performances du dispositif d'asservissement conforme à l'invention sont de ce fait nettement supérieures à celles de l'ensemble des systèmes existant.

En effet, il permet d'atteindre une précision de mesure et d'asservissement du champ magnétique de l'ordre de 10⁻⁶ avec une résolution d'environ 10⁻⁷ T et une plage opérationnelle s'étendant de 0,1 T à 1,2 T.

## Revendications

1. Dispositif d'asservissement d'un champ magnétique, comportant un capteur disposé dans le champ magnétique à asservir et une boucle d'asservissement contrôlant le module d'alimentation de l'aimant générateur dudit champ magnétique, ledit capteur se présentant sous la forme d'un oscillateur hyperfréquence à résonateur au grenat d'yttrium ferreux, générant un signal de mesure dont la fréquence est proportionnelle à l'intensité du champ magnétique, caractérisé en ce que la boucle d'asservissement (2) est composée, d'une part, d'un dispositif (5) de traitement et de mise en forme du signal de mesure délivré par le capteur (1), constitué par un mélangeur harmonique (7) combinant le signal de mesure issu du capteur (1) avec un signal de référence délivré par un oscillateur (8) à grande stabilité, le signal composé résultant étant soumis à un filtre passe-bande (9), et, d'autre part, d'un dispositif (6) de comparaison de la fréquence dudit signal de mesure avec celle d'un signal de consigne et de génération d'un signal correcteur, qui comporte un mélangeur harmonique (10), recevant le signal traité et mis en forme et le combinant avec un signal de consigne issu d'un synthétiseur hyperfréquence (11) programmable, et un discriminateur de fréquence (12) consécutif, relié à un générateur (13) d'un signal de correction correspondant délivré au module d'alimentation (3) de l'aimant (4) à contrôler.

2. Procédé d'asservissement d'un champ magnétique mettant en oeuvre le dispositif selon la revendication 1, consistant essentiellement à générer, par l'intermédiaire d'un oscillateur (1) à résonateur au grenat d'yttrium ferreux utilisé comme capteur de mesure, un signal de mesure dont la fréquence est proportionnelle à l'intensité du champ magnétique généré par l'aimant à contrôler, caractérisé en ce qu'il consiste, en outre, à mélanger ensuite ledit signal de mesure avec un signal de référence, puis à mélanger, après filtrage, le signal composé résultant avec un signal de consigne, au moyen d'un mélangeur harmonique (10), à démoduler le signal ainsi obtenu en effectuant une discrimination de fréquence et, enfin, à délivrer un signal de correction, fonction de l'écart de fréquence entre le signal composé et le signal de consigne, au module d'alimentation (3) de l'aimant (4) générateur du champ magnétique à asservir.

## Patentansprüche

1. Vorrichtung zur Regelung eines Magnetfelds, die einen in dem zu regelnden Magnetfeld angebrachten Aufnehmer und einen das Speisungsmodul des Erzeugermagnets des Magnetfelds regelnden Regelkreis aufweist, wobei der Aufnehmer in Form eines Höchstfrequenzoszillators mit einem Yttrium-Eisen-Granat-Resonator ausgeführt ist, der ein Meßsignal erzeugt, dessen Frequenz proportional ist zur Intensität des Magnetfelds,
dadurch gekennzeichnet, daß der Regelkreis (2) zusammengesetzt ist einerseits aus einer Vorrichtung (5) zur Behandlung und Formung des von dem Aufnehmer (1) gelieferten Meßsignals, die aus einem harmonischen Mischer (7) gebildet ist, der das von dem Aufnehmer (1) ausgegebene Signal mit einem von einem Oszillator (8) mit hoher Stabilität gelieferten Referenzsignal kombiniert, wobei das resultierende zusammengesetzte Signal einem Bandpaßfilter (9) zugeführt wird, und andererseits aus einer Vorrichtung (6) zum Vergleich der Frequenz des Meßsignals mit der eines Soll-Signals und Erzeugung eines Korrektursignals, die einen harmonischen Mischer (10) aufweist, der das behandelte und geformte Signal empfängt und es mit einem von einem programmierbaren Höchstfrequenzsynthetisierer (11) ausgegebenen Soll-Signal kombiniert, und einen nachfolgenden Frequenzdiskriminator (12), der mit einem Generator (13) eines entsprechenden, an das Speisungsmodul (3) des zu steuernden Magnets (4) gelieferten Korrektursignals verbunden ist.

2. Verfahren zur Regelung eines Magnetfelds, in dem die Vorrichtung nach Anspruch 1 eingesetzt wird, das im wesentlichen darin besteht, mittels eines Oszillators mit einem Yttrium-Eisen-Granat-Resonator, der als Meßaufnehmer verwendet wird, ein Meßsignal zu erzeugen, dessen Frequenz proportional ist zur Intensität des von dem zu steuernden Magneten erzeugten Magnetfelds, dadurch gekennzeichnet, daß es außerdem darin besteht, dann das Meßsignal mit einem Referenzsignal zu mischen, dann, nach Filtern, das resultierende, zusammengesetzte Signal mit einem Soll-Signal mittels eines harmonischen Mischers (10) zu mischen, das so erhaltene Signal durch Ausführung einer Frequenzdiskrimination zu demodulieren und schließlich ein Korrektursignal, als Funktion der Frequenzabweichung zwischen dem zusammengesetzten Signal und dem Soll-Signal, an das Speisungsmodul (3) des Erzeugermagnets (4) des zu regelnden Magnetfelds zu liefern.

## Claims

1. Apparatus for controlling a magnetic field comprising a sensor disposed in the magnetic field to be controlled and a control loop for controlling the supply module of the magnet generating said magnetic field, said sensor being in the form of a hyperfrequency oscillator with a ferrous yttrium stone resonator generating a measurement signal whose frequency is proportional to the strength of the magnetic field, characterised in that the control loop (2) is composed on the one hand of a device (5) for processing and shaping the measurement signal delivered by the sensor (1), formed by a harmonic mixer (7) combining the measurement signal from the sensor (1) with a reference signal delivered by a high-stability oscillator (8), the resulting composite signal being passed through a pass band filter (9) and, on the other hand, a device (6) for comparing the frequency of said measurement signal to that of a standard signal and for generating a corrector signal, which comprises a harmonic mixer (10) receiving the processed and shaped signal and combining it with a standard signal from a programmable hyperfrequency synthesiser (11), and a subsequent frequency discriminator (12) connected to a generator (13) for generating a corresponding correction signal which is delivered to the supply module (3) of the magnet (4) to be controlled.

2. A process for controlling a magnetic field using the apparatus according to claim 1 essentially comprising generating by means of an oscillator (1) with a ferrous yttrium stone resonator used as a measuring sensor a measurment signal whose frequency is proportional to the strength of the magnetic field generated by the magnet to be controlled, characterised in that it further comprises then mixing said measurement signal with a reference signal and then after filtration mixing the resulting composite signal with a standard signal, by means of a harmonic mixer (10), demodulating the signal obtained in that way by effecting frequency discrimination and finally delivering a correction signal dependent on the frequency difference between the composite signal and the standard signal to the supply module (3) of the magnet (4) generating the magnetic field to be controlled.
